# EUROPEAN PATENT SPECIFICATION

(11) **EP 2 456 294 B1**
(45) Date of publication and mention of the grant of the patent: **08.04.2015**
(21) Application number: 12154219.5
(22) Date of filing: 28.11.2007
(51) Int. Cl.: H05K 7/20, H02M 7/00

(54) **Inverter**
Inverter
Onduleur

(43) Date of publication of application: 23.05.2012
(62) Divisional of application: 07847473.1
(73) Proprietor: Robert Bosch GmbH, 70442 Stuttgart (DE)
(72) Inventor: Dr. Knaup, Peter, 64673 Zwingenberg (DE); Gonska, Gernot, 64807 Dieburg (DE)

(56) References cited:
- EP-A2- 0 900 621
- DE-U1-202004 009 926
- JP-A- 2003 209 375
- US-A1- 2004 095 730
- US-A1- 2005 195 574

## Description

### Field of the Invention

The invention relates to an inverter or other electronically controlled power source for transforming electrical energy of predefined voltage and/or current. Further, the invention relates to a method for setting up and operating an inverter or other electronically controlled power source.

### State of the Art

Inverter and other electronically controlled power sources for transforming electrical energy of predefined voltage and/or current are generally known. Such inverters are generally known and used to provide electrical energy of predefined voltage and / or current. To give one example, such inverters are used to transform electrical DC-energy provided by a solar generator into a basically sinusoidal current signal for feeding into a public or private grid. E.g. a 60 Hz signal for the public grid in the United States or a 50 Hz signal for the public European grid.

For transforming the electrical energy at least some power loss within the inverter is unavoidable. In particular such power loss appears at semiconductor switching elements such as IGBTs and also at chokes. To avoid malfunction of the inverter, in particular of the lossy components at which the power loss basically appears, cooling is necessary to avoid exceeding of a certain temperature.

Additionally, the inverter might not only suffer from heat generated by the electronic or electrical components but also by the sun. In particular if the inverter is used in connection with a solar generator, a high level of radiation of the sun is expected. This results in a dilemma for the designer of the inverter. I.e. the inverter could be isolated against heating of the sun but on the other hand an isolation might also make dissipating of heat more difficult.

However, it is also one general demand for an inverter to be sealed against water and dust and the like to protect the inverter. From the German utility model DE 20 2004 009 926 U1 an inverter is known comprising two chambers. These two chambers are separated by one wall that comprises the lossy components. One chamber comprises a cooling aggregate and each lossy component or a heat sink of it is attached directly to the separating wall and facing the chamber of the cooling aggregate.

However, such a common wall providing the lossy components might conduct heat from a lossy component to its heat sink, but it also conducts heat in the reverse direction, i.e. from the chamber comprising the cooling aggregate to the chamber comprising the other electronic components, which are not considered to be lossy but still may not get too hot. Also, the success of cooling basically depends on the efficiency of the cooling aggregate. Therefore, the success also depends on the energy provided for the cooling aggregate. Such an inverter does also not solve the dilemma of protection of the inverter against the heat of the sun and simultaneously still being able of dissipating heat generated within the inverter.

Document US 2005/195574 A1 discloses a low-cost heat sink easy to assemble which is designed to be mounted on a power semiconductor module through the medium of cooling water includes a base member, a heat sink body superposed on the base member to form in cooperation with the base member a passage through which the coolant flows, and a bellows-like flow straightening plate disposed between the power semiconductor module and the base member in physical contact with the power semiconductor module on one hand and with the base member on the other hand. The flow straightening plate partitions the passage into a plurality of flow straightening channels.

### Object of the invention

Accordingly it is at least one object of the invention to provide an inverter which reduces at least one of the above problems and to provide a method of setting up and/or operating such an inverter. In particular, it is one object of the invention to improve the capabilities of an inverter regarding dissipating of heat and protection against heat. A further object of the present invention is to improve the efficiency of the inverter regarding the dissipating of generated heat and protection against heat from outside.

To achieve these and other objects the invention proposes an inverter or other electronically controlled power source for transforming electrical energy into electrical energy of predetermined voltage and/or current as defined in claim 1.

Accordingly, the invention proposes an inverter having an inner housing for housing the main circuitry of the inverter. Of course, if another electronically controlled power source is used, the inner housing comprises the main circuitry of that other power source. Such main circuitry usually comprises of one main circuit board having the most or even all electronic components attached, either directly or by means of further smaller circuit boards. Only special parts of the inverter that are necessarily or at least usually located outside might not be housed in the inner housing, such as an operating panel or a display. Also, a choke which is used for filtering our smoothing the generated current or other component dissipating high amount of energy might not be inside this inner housing.

A cover may be connected to this inner housing, covering at least part of the inner housing, defining at least one cover channel between the inner housing and the cover. Such cover channel is designed as an air channel for air to flow through this channel to cool the inverter, provided that the air is cooler than the inverter. The channel is provided such, that natural convection of the air is facilitated. Natural convection of air takes place according to warmer air ascending in an environment of cooler air. The force of such natural convection is, compared to an airflow generated by a fan or a vent, usually weak. The channel to facilitate natural convection must therefore comprise a relatively large cross sectional area. Of course, such channel must be of generally vertical orientation to let the warmer airflow upwards.

The inverter comprises at least one heat sink for cooling power components of the inverter, whereby the heat sink is attached to the inner housing basically providing a space between the heat sink and the inner housing.

Such a heat sink usually consists of a base with one or more flat surfaces and an array of comb or fin-like protrusions to increase the heat sink's surface area contacting the air. Contrary to known systems the base does not provide one wall of the inner housing nor is the base and in particular such a flat surface directly connected to a wall having a large contact area. Instead, the invention proposes to leave a space such as a gap between the heat sink and the inner housing, in particular between the base or base plate of the heat sink and a wall of the inner housing. This way, it is avoided that heat in the heat sink is conducted back to such wall of the inner housing and thus back to the inner housing. Accordingly this avoids any reversely directed flow of heat back into the housing. This aspect shall improve the cooling properties of the inverter with respect to the heat sink. This aspect may improve the heating properties of an inverter independently to the aspect of providing a cover to further provide a cover channel. However, both of these general features may be combined having synergetic effects.

According to an embodiment of the invention the inner housing is sealed against the environment to prevent the circuitry of the inverter against dust and/or water. This way, a good protection can protect the circuitry of the inverter by means of a sealed inner housing, whereby good cooling properties can still be achieved.

According to a further embodiment power components which need external cooling, e.g. semiconductor switches such as IGBTs, or other components dissipating a high amount of energy extend through the casing of the inner housing against the heat sink and/or are sealed against the inner housing. Accordingly, such power components may be attached to the same circuit board as all other components which do not need cooling. But these power components extend through the casing of the inner housing, in particular through a wall of inner housing, extend through the space or gap between the inner housing and the heat sink and finally are attached against the heat sink e.g. at a base or base plate of it. This way the power components are mounted at the heat sink for conducting heat generated in the power components to the heat sink but the inner housing remains sealed and a distance between the inner housing and the heat sink does also remain.

Advantageously the heat sink comprises a base plate having one or a plurality of power components attached to that base plate, whereby the base plate comprises protrusions extending towards the power components so as to provide a base for each attached power component. Such protrusion can extend at least partly through a gap or space between the base plate and the inner housing. This way even flat components electrically connected within the inner housing can be attached to the base plate and a gap or space can still be provided between the base plate and the inner housing. According to one embodiment, at least one of such protrusions can extend through the gap or space into the housing for being attached to a component that needs cooling, whereby the protrusion is sealed against the wall of the inner housing. Therefore, the protrusion can conduct heat of that component to the base plate of the heat sink, whereas conducting heat from the base plate back to the inner housing is avoided due to the gap or space between the base plate.

As proposed according to one embodiment the heat sink may be attached to the inner housing by means of distance pieces. E.g. the heat sink might be screwed at four corners of the heat sink through such distance pieces and into the inner housing. Such distance pieces might be provided as cylinders of a material that does not conduct heat very well, such as a plastic material, or a ceramic material or resin or such alike. The distance pieces may also take the form of two bars holding the heat sink at two sides.

It is also to be noted, that at least one main circuit board in the inner housing does not necessarily need to be attached to a wall of the inner housing facing towards the heat sink, but there might also be provided a gap between such circuit board and the wall of the inner housing, to have a further distance providing a further heat protection of the circuit board.

In a further embodiment the inverter comprises a heat sink channel accommodating the heat sink for guiding air long the heat sink for cooling this way, providing an air stream along the heat sink is facilitated. If the heat sink comprises a plurality of fin-like protrusions, the heat sink channel is oriented in the same direction as the fin-like protrusions are.

According to one embodiment an airflow along the heat sink is enhanced by means of at least one vent for blowing air through the heat sink channel along the heat sink and in particular also through the space or gap between the inner housing and the heat sink. This way, the heat sink channel ensures a certain direction of an airflow whereas the vent provides for or increases the velocity of such air stream. As the heat sink is basically not attached with the large surface of a base of it to the inner housing, this surface of the base can also be used for dissipating heat by means of an air stream. Therefore, the vent not only blows the air along the finlike protrusions but also along such surface facing the inner housing and thus facing the space or gap between them.

According to a further aspect it is proposed to provide the output opening of the cover channel adjacent to an output opening of the heat sink channel. This way, the hot air coming out of both output openings may be directed in the same direction. Even though the cover channel and the heat sink channel are basically independent of each other the arrangement of both openings next to each other might result in a suction effect from the one channel to the other one. In particular, if the heat sink channel is provided with at least one a vent whereas the cover channel is not provided with a vent the air of the heat sink channel might flow with a higher velocity and thus the cover channel might be subjected to a suction effect resulting from the higher velocity of the heat sink channel.

### Brief Description of the Figures

Preferred embodiments of the invention are described with reference to the accompanying figures, wherein
- Fig. 1: shows a perspective view of a first embodiment of an inverter according to the invention,
- Fig. 2: shows a front view of the embodiment according to figure 1,
- Fig. 3: shows a back view of the embodiment of figure 1,
- Fig. 4: is a cross sectional view of the embodiment of figure 3 according to the arrows A-A of figure 3,
- Fig. 5: shows a cross sectional view of the embodiment of figure 3 according to the arrows B-B of figure 3, in greater detail and
- Fig. 6: shows a bottom plan view of the embodiment of figures 1-5.

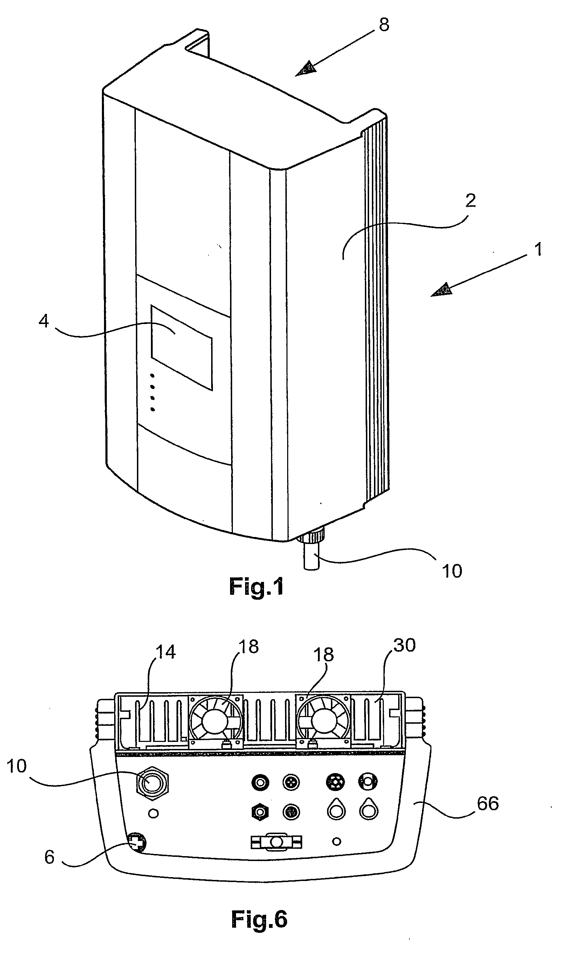

Figure 1 shows an inverter 1 having a cover 2. And according to the perspective of figure 1 the cover 2 basically completely covers the inverter 1, as the perspective according to figure 1 equals one possible direction of the sun radiation. Attached to the cover 2 is a display 4 for displaying inverter related information. At the bottom of the inverter 1 there is also shown a drainage adapter 6. At the top and back edge of the inverter 1 there is indicated a common opening 8 for air to exit the inverter 1.

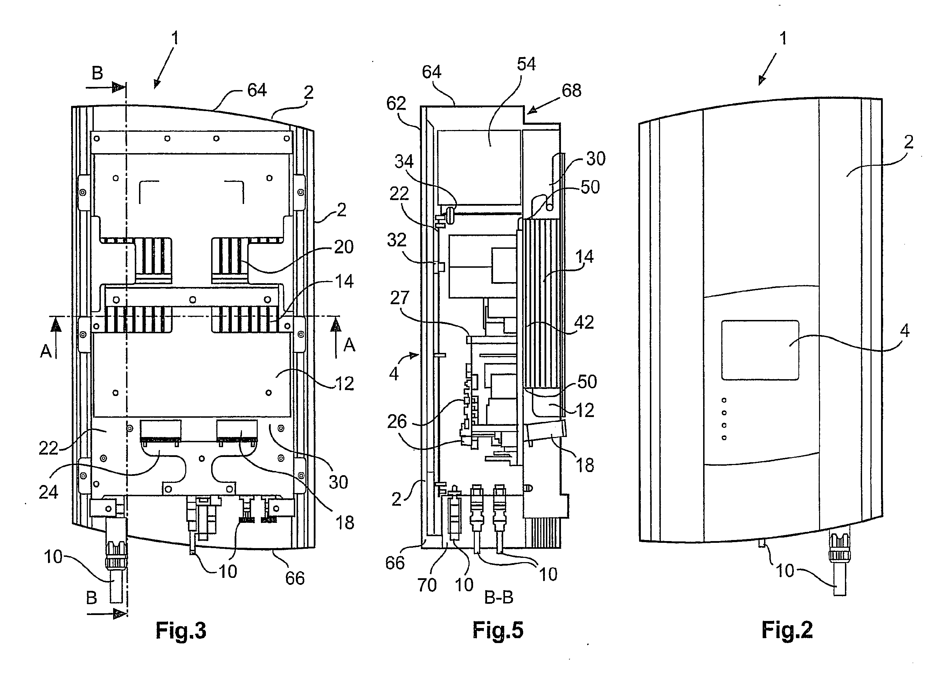

Figure 2 also shows the cover 2, display 4 and the drainage adapter 6 of the inverter 1. In that front view a connector 10 is also indicated at the bottom side of the inverter 1.

According to the back view of figure 3 only part of the cover 2 can be seen basically at both sides and at the top and the bottom of the inverter 1. Attached to the inverter 1 at its backside is a cover plate 12 partly covering a heat sink 14 and thus forming a heat sink channel 30 of a basically open configuration. It is to be noted, that the cover plate 12 covering the heat sink does not form part of the cover 2 for forming a cover channel. To blow air in an upward direction, two vents 18 are positioned below the heat sink 14 and will, when in operation, blow air to the heat sink 14 and along the fin-like structure 20 of the heat sink.

Figure 3 also shows in its bottom area a part of the back side of the inner housing 22. Attached to this inner housing are the vents 18 using an attachment means 24. The back view according to figure 3 shows further connectors 10 or connecting adapters for electrically connecting the inverter 1.

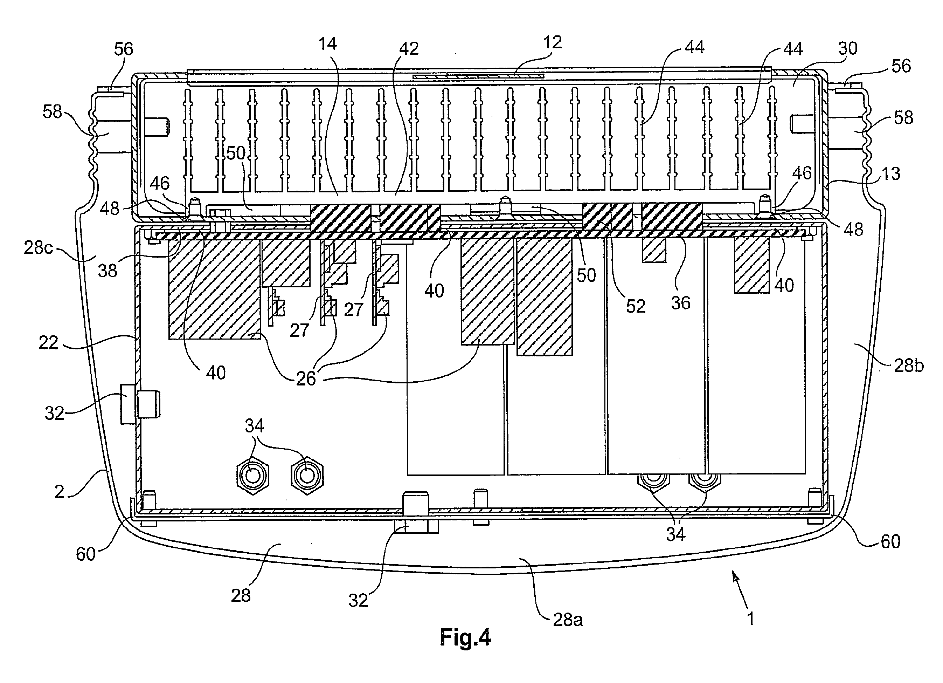

Figure 4 shows a cross sectional view from a bottom perspective according to an intersection indicated by arrows A-A in figure 3. This view illustrates the subdivision of the inverter 1. Accordingly, the inverter 1 consists basically of an inner housing 22 enclosing electronic components, a cover channel 28 defined between the cover 2 and the inner housing 22 and a heat sink area or heat sink channel 30 basically defined between the inner housing 22 and a heat sink plate 12 and/or a device such as a wall to which the inverter 1 is attached.

The inner housing 22 is sealed against the environment and a pressure compensation adapter 32 is provided to fulfil a pressure equalisation if necessary. Accordingly, all electrical connections 10 (cf. figure 3 and figure 5) as well as connections 34 for proving a connection to chokes positioned on top of the inner housing 22 are adapted to ensure the sealed state of the inner housing 22.

The electronic components 26 are basically arranged on a main circuit board 36, that is arranged in a plane parallel to a back wall 38 of the inner housing 22 but comprising a gap 40 between the main circuit board 36 at the back wall 38. Many of the components 26 do not produce considerable heat and are arranged at the main circuit board 36 facing to the inside of the inner housing 22. Some of these components 26 are arranged on smaller circuit boards 27, which are attached or connected to the main circuit board 36. It is to be noted, that the electronic components 26, including the smaller circuit boards 27 are only shown in a schematic way and the components, the number of the components, the certain arrangement and so on may vary with respect to different inverters. However, the used electronic components and thus any possible variations are not of importance for the present invention.

The heat sink channel 30 is basically defined by the heat sink plate 12 and/or a device such as a wall to which the inverter 1 is attached and a support frame 13. The support frame 13 is attached to the inner housing 22 at the back wall 38 and does support the heat sink 14. The heat sink 14 comprises one base plate 42 and a plurality of fin-like means 44 for enlarging the surface of the heat sink 14. At the base plate 42 there are provided protrusions 46, on which the heat sink 14 is attached to the support frame 13 by means of screws 48.

The protrusions 46 function as distance pieces integrally formed with the heat sink 14, to provide a gap 50 between the base plate 42 of the heat sink 14 and the support frame 13. Accordingly, a gap 50 is provided between the heat sink 14 and the inner housing 22. According to another embodiment, there are further fin-like means at the base plate protruding into the gap, to further increase the surface of the heat sink.

According to figure 4, some power components 52, that need cooling during operation of the inverter 1 are mounted at the main circuit board 36, but face into the direction of the heat sink 14. These power components 52 extend through the back wall 38 of the inner housing 22 to the base plate 42 of the heat sink 14. These power components 52 are sealed against the back wall 38 of the inner housing 22. The power components are with one side attached to the base plate 42 of the heat sink 14 such, that good heat conduction from the power components 52 to the heat sink 14 is provided. Accordingly, any heat conducting connection between the inner housing and the heat sink 14 is only provided by means of the power components 52 themselves. Such heat conducting connection is necessary but any other heat conduction connections between the inner housing and the heat sink are avoided. The gap 50 between the base plate 42 of the heat sink 14 and the back wall 38 of the inner housing 22 also provides for an air channel so air can flow through this gap and provide further cooling for the heat sink as well as for the back wall 38 and thus for the inner housing 22.

A cover 2 is at two sides attached to the support frame 13 at attachment lash 56 further involving support means 58. Because the cover 2 almost touches edges 60 of the inner housing 22, the cover channel 28 is basically subdivided in a front and two side cover channels 28 a-c. A cover channel 28 and also the sub channels 28a-c according to figure 4 provide a relatively large cross sectional area. Accordingly, there is no strong flow resistance hindering an upward air stream and thus the cover channel 28 and the sub channels 28 a-c provide for natural convection of air.

The cross sectional view according to figure 5 provides basically a side perspective of the inverter 1. Accordingly, the vent 18 is arranged below the heat sink 14 and adapted to provide an air stream having an upwards direction to flow along the heat sink 14. Figure 5 also shows a slightly inclined position of the vent 18 and accordingly the vent 18 ensures to also blow air into the gap 50 between the inner housing 22 and the base plate 42 of the heat sink.

Figure 5 more clearly shows some components of the inner housing 22, i.e. the drainage adapter 6, connectors 10 and electronic components 26 and smaller circuit boards 27. Above the inner housing 22 a choke 54 is positioned and connected via the connection 34 to the inner housing.

The cover 2, as seen in figure 5 comprises a front cover 62, a top cover 64 and a bottom skirt 66. The top cover 64 completely covers the upper side of the inner housing 22 and the chokes 54 arranged above the inner housing 22 at the top side. The cover 2 further provides a top opening 68 of the cover channel 28. The air flowing upwards in the cover channel 28 will thus exit the cover channel 28 at the top opening 68. It can also be seen, that the choke 54 is basically positioned in the cover channel 28 at one side of it. The top opening 68 thus basically faces in a backwards direction.

A bottom opening 70 for air to enter the cover channel 28 is basically positioned next to the bottoms skirt 66, facing in a downward direction.

Figure 6 illustrates the shape of the skirt 66, basically forming a stripe like form according to the bottom view of this figure. This figure also shows the drainage adapter 6, connectors 10, vents 18 and a heat sink 14 that is partly provided in a heat sink channel 30.

When operating the inverter 1 air in the cover channel 28 will be heated in particular by means of the chokes 54 and by means of the cover 2 when being heated by the sun. Accordingly, the heated air will flow upwards according to natural convection and as a result cooler air from the outside will flow into the bottom opening 70 and thus cool the inner housing 22 and the cover 2 of the inverter, while gradually being heated in the cover channel. The heated air flowing upwards will exit the cover channel 28 at the top opening 68. For cooling the power components and thus cooling the heat sink 14, the vents 18 will blow air along the heat sinks 14, in particular along the fin-like means 44 and through the gap 50 along the base plate 42. This air will be heated by the heat sink and will be flowing in the heat sink channel. This hot air will exit the heat sink channel 30 in an area close to the top opening 68 of the cover channel 28. In this area, the air of the cover channel 28 and the air of the heat sink channel 30 will come together. Because of the vents 18 the air in the heat sink channel usually has a larger velocity than the air in the cover channel 2, the air exiting the heat sink channel 30 might provide a suction effect on the air in the cover channel 22 and thus might accelerate the air flow in the cover channel 28.

## Claims

1. Inverter or other electronically controlled power source for transforming electrical energy into electrical energy of predetermined voltage and/or current comprising:
an inner housing (22) for housing the main circuitry of the inverter,
at least one heat sink (14) for cooling power components (52) of the main circuitry, the heat sink consisting of a base plate (42) with one or more flat surfaces and an array of comb or fin-like protrusions (44);
whereby the heat sink is attached to the inner housing, basically providing a space (50) between the base plate of the heat sink and a wall of the inner housing, such that any reversely directed heat flow bach into the housing is avoided.

2. Inverter according to claim 1, whereby the inner housing is sealed against the environment to protect the circuitry of the inverter against dust and/or water.

3. Inverter according to claim 1 to 2, whereby power components which need external cooling extend through the casing of the inner housing against the heat sink and are sealed against the inner housing.

4. Inverter according to any of the claims 1 to 3, whereby the heat sink comprises a base plate having one or a plurality of power components attached to that base plate, whereby the base plate comprises protrusions extending towards the power components so as to provide a base for each attached power component.

5. Inverter according to any of claims 1 to 4, whereby the heat sink is attached to the inner housing by means of distance pieces.

6. Inverter according to any of the claims 1 to 5, further comprising a heat sink channel accommodating the heat sink for guiding air along the heat sink for cooling.

7. Inverter according to claim 6, further comprising at least one vent for blowing air through the heat sink channel along the heat sink, in particular also through the space between the inner housing and the heat sink.

8. Inverter according to any of the claims 1 to 7, comprising a cover connected to the inner housing, covering at least part of the inner housing, defining at least one cover channel between the inner housing and the cover for air to flow through that channel for cooling the inverter, wherein the cover channel is adapted to facilitate natural convection of the air whereby an or the output opening of the cover channel is adjacent to an output opening of the heat sink channel.

## Patentansprüche

1. Inverter oder andere elektronisch gesteuerte Stromquelle zum Transformieren von elektrischer Energie in elektrische Energie mit vorgegebener Spannung und/oder vorgegebenem Strom, aufweisend:
ein Innengehäuse (22) zum Einfassen der Hauptschaltungen des Inverters,
zumindest eine Wärmesenke (14) zum Kühlen von Leistungskomponenten (52) der Hauptschaltungen, wobei die Wärmesenke aus einer Grundplatte (42) mit einer oder mehreren flachen Oberflächen und einer Gruppierung von kamm- oder rippenartigen Vorsprüngen (44) besteht,
wobei die Wärmesenke am Innengehäuse angebracht ist und im Grunde einen Raum (50) zwischen der Grundplatte der Wärmesenke und einer Wand des Innengehäuses vorsieht, sodass jeglicher umgekehrt gerichteter Wärmestrom zurück in das Gehäuse vermieden ist.

2. Inverter nach Anspruch 1, wobei das Innengehäuse zur Umgebung hin zum Schützen der Schaltungen des Inverters gegen Staub und/oder Wasser abgedichtet ist.

3. Inverter nach einem der Ansprüche 1 oder 2, wobei Leistungskomponenten, die externe Kühlung benötigen, durch die Ummantelung des Innengehäuses an der Wärmesenke verlaufen und zum Innengehäuse hin abgedichtet sind.

4. Inverter nach einem der Ansprüche 1 bis 3, wobei die Wärmesenke eine Grundplatte mit einer oder mehreren Leistungskomponenten, die an dieser Grundplatte angebracht sind, aufweist, wobei die Grundplatte Vorsprünge aufweist, die zu den Leistungskomponenten hin verlaufen, um eine Basis für jede angebrachte Leistungskomponente vorzusehen.

5. Inverter nach einem der Ansprüche 1 bis 4, wobei die Wärmesenke mittels Distanzstücken am Innengehäuse angebracht ist.

6. Inverter nach einem der Ansprüche 1 bis 5, ferner aufweisend einen Wärmesenkenkanal, der die Wärmesenke zum Leiten von Luft entlang der Wärmesenke zum Kühlen aufnimmt.

7. Inverter nach Anspruch 6, ferner aufweisend mindestens ein Luftloch zum Blasen von Luft durch den Wärmesenkenkanal entlang der Wärmesenke, insbesondere außerdem durch den Raum zwischen dem Innengehäuse und der Wärmesenke.

8. Inverter nach einem der Ansprüche 1 bis 7, aufweisend eine Abdeckung, die mit dem Innengehäuse verbunden ist, mindestens einen Teil des Innengehäuses abdeckt und mindestens einen Abdeckungskanal zwischen dem Innengehäuse und der Abdeckung für Luft zum Strömen durch diesen Kanal zum Kühlen des Inverters definiert, wobei der Abdeckungskanal zum Ermöglichen freier Konvektion der Luft geeignet ist, wobei eine oder die Ausgangsöffnung des Abdeckungskanals einer Ausgangsöffnung des Wärmesenkenkanals benachbart ist.

## Revendications

1. Onduleur ou autre source électrique commandée électroniquement pour convertir une énergie électrique en une énergie électrique ayant une tension et/ou un courant prédéterminés, comprenant :
un boîtier interne (22) pour recevoir le circuit principal de l'onduleur ;
au moins un dissipateur thermique (14) afin de refroidir les composants de puissance (52) du circuit principal, lequel dissipateur thermique comprend une plaque de base (42) avec une ou plusieurs surfaces planes et un réseau de protubérances de type peigne ou ailettes (44) ;
lequel dissipateur de chaleur est fixé au boîtier interne et définit essentiellement un espace (50) entre la plaque de base du dissipateur thermique et une paroi du boîtier interne de manière à empêcher tout flux de chaleur dirigé en sens inverse de revenir dans le boîtier.

2. Onduleur selon la revendication 1, dans lequel le boîtier interne est hermétique à l'environnement afin de protéger le circuit de l'onduleur contre la poussière et/ou l'eau.

3. Onduleur selon les revendications 1 à 2, dans lequel les composants de puissance qui nécessitent un refroidissement externe s'étendent dans l'enceinte du boîtier interne contre le dissipateur thermique, et sont scellés contre le boîtier interne.

4. Onduleur selon l'une quelconque des revendications 1 à 3, dans lequel le dissipateur thermique comprend une plaque de base comportant un ou plusieurs composants de puissance fixés sur cette plaque de base, laquelle plaque de base comprend des protubérances s'étendant vers les composants de puissance de manière à former une base pour chacun des composants de puissance fixés.

5. Onduleur selon l'une quelconque des revendications 1 à 4, dans lequel le dissipateur thermique est fixé au boîtier interne par le biais de pièces de distanciation.

6. Onduleur selon l'une quelconque des revendications 1 à 5, comprenant en outre un canal de dissipateur thermique recevant le dissipateur thermique afin de guider de l'air le long du dissipateur thermique en vue du refroidissement.

7. Onduleur selon la revendication 6, comprenant en outre au moins un évent afin de souffler de l'air à travers le canal du dissipateur thermique le long du dissipateur thermique, et notamment aussi à travers l'espace entre le boîtier interne et le dissipateur thermique.

8. Onduleur selon l'une quelconque des revendications 1 à 7, comprenant un cache connecté au boîtier interne recouvrant une partie au moins du boîtier interne, définissant au moins un canal de cache entre le boîtier interne et le cache pour que l'air circule à travers ce canal afin de refroidir l'onduleur, lequel canal de cache est conçu pour faciliter la convection naturelle de l'air, et dans lequel une ou l'ouverture de sortie du canal de cache est adjacente à une ouverture de sortie du canal du dissipateur thermique.
